# FASCICULE DE BREVET EUROPEEN

(11) **EP 0 772 359 B1**
(45) Date de publication et mention de la délivrance du brevet: **16.01.2002**
(21) Numéro de dépôt: 96202966.6
(22) Date de dépôt: 24.10.1996
(51) Int. Cl.: H04N 7/10, H03J 5/24

(54) **Dispositif de filtrage pour traiter une pluralité de canaux dans un système de distribution de télévision par câble**
Filtervorrichtung zur Verarbeitung einer Vielzahl von Kanälen in einem Kabelfernsehverteilungssystem
Filtering device for processing a plurality of channels in a cable television distribution system

(30) Priorité: 31.10.1995 FR 9512866
(43) Date de publication de la demande: 07.05.1997
(73) Titulaire: Koninklijke Philips Electronics N.V., 5621 BA Eindhoven (NL)
(72) Inventeur: Chanteau, Pierre, Société Civile S.P.I.D., 75008 Paris (FR); Deville, Yannick, Société Civile S.P.I.D., 75008 Paris (FR); Friedel, Paul, Société Civile S.P.I.D., 75008 Paris (FR)
(74) Mandataire: Charpail, François

(56) Documents cités:
- WO-A-91/11857
- GB-A- 2 146 190
- US-A- 4 259 744
- US-A- 4 550 292
- IEEE JOURNAL OF SOLID-STATE CIRCUITS, vol. SC-21, no. 1, Février 1986, pages 15-30, XP000577205 Y. TSIVIDIS ET AL.: "Continuous-Time MOSFET-C FIlters in VLSI"
- IEE PROCEEDINGS G. ELECTRONIC CIRCUITS & SYSTEMS, vol. 136, no. 4, PART G, Août 1989, pages 184-190, XP000046407 SCHAUMANN R: "DESIGN OF CONTINUOUS-TIME FULLY INTEGRATED FILTERS: A REVIEW"
- PROCEEDINGS OF THE INTERNATIONAL SYMPOSIUM ON CIRCUITS AND SYSTEMS, PORTLAND, MAY 8 - 11, 1989, vol. 1 OF 3, 8 Mai 1989, INSTITUTE OF ELECTRICAL AND ELECTRONICS ENGINEERS, pages 106-109, XP000131574 SCHAUMANN R ET AL: "THE PROBLEM OF ON-CHIP AUTOMATIC TUNING IN CONTINUOUS-TIME INTEGRATED FILTERS"

## Description

La présente invention concerne un dispositif de filtrage dans lequel, à un filtre dit esclave comportant au moins une cellule dont la fréquence centrale est commandée par une tension appliquée à une entrée de commande de fréquence, correspond un filtre maître muni d'une cellule d'un type identique à celui employé dans le filtre esclave et de moyens de servo-régulation pour aligner, au moyen d'une tension de commande de fréquence, la fréquence centrale de cette cellule avec la fréquence d'un signal fourni par un synthétiseur de fréquences composé d'un oscillateur à fréquence variable et d'un circuit de rétro-action dit PLL qui génère une tension de syntonisation de l'oscillateur, dispositif dans lequel, pour aligner la fréquence du filtre esclave, la dite tension de commande est appliquée en même temps à l'entrée de commande de fréquence du filtre maître et à celle du filtre esclave.
L'invention concerne également un système de distribution collective de télévision.

Un dispositif de filtrage selon le préambule ci-dessus est connu du document intitulé "Design of continuous-time fully integrated filters : a review", dans IEE Proceedings Electronic Circuits & Systems, vol 136, no 4, part G, août 1989, pages 184-190.

Un objet de l'invention est de procurer un système de distribution collective de télévision dont la fabrication soit économique, et qui ne dérive pas lorsqu'il vieillit.
A cet effet, le dispositif de filtrage selon la revendication 1 étant utilisé pour traiter individuellement une pluralité de canaux dans un système de distribution de télévision par câble comportant une pluralité de voies en parallèle munies chacune d'un filtre esclave de type passe-bande, le dispositif comporte autant de filtres maîtres et d'oscillateurs que de filtres esclaves, tous étant réalisés par intégration sur un même substrat semi-conducteur, et un seul circuit PLL, des moyens de commutation étant prévus pour sélectionner tour à tour les différents oscillateurs, en amenant le signal de l'oscillateur sélectionné au circuit PLL et en ramenant à cet oscillateur la tension de syntonisation issue du circuit PLL, ainsi que des moyens pour caler la fréquence définie par le circuit PLL sur la fréquence désirée pour l'oscillateur qui est sélectionné, et un moyen de mémorisation provisoire pour chaque oscillateur, de façon à conserver la valeur de la tension de syntonisation, pendant des périodes où il n'est pas sélectionné.
Avantageusement, le dit moyen de mémorisation provisoire pour chaque oscillateur est constitué essentiellement par un condensateur réservoir.
Un tel moyen est économique et simple.
Dans une autre forme de réalisation, le dispositif de filtrage selon la revendication 3 étant utilisé pour traiter individuellement une pluralité de canaux dans un système de distribution de télévision par câble comportant une pluralité de voies en parallèle munies chacune d'un filtre esclave de type passe-bande,'le dispositif comporte autant de filtres maîtres que de filtres esclaves, tous étant réalisés par intégration sur un même substrat semi-conducteur, et un seul oscillateur, dont la sortie de signal est reliée, au moyen d'un commutateur, tour à tour aux différentes entrées de signal des différents filtres maîtres, et la tension de commande de fréquence de chacun de ces filtres maîtres est amenée au filtre esclave correspondant, au moyen d'une pluralité d'interrupteurs insérés à chaque fois dans la connexion reliant un filtre esclave à un filtre maître et qui sont fermés seulement pendant les périodes où la sortie de signal de l'oscillateur est reliée au filtre maître correspondant.
Avantageusement, pour mémoriser la tension de commande de fréquence de chaque filtre esclave, une capacité est connectée à l'entrée de commande de fréquence de chaque filtre esclave.
Un tel moyen est économique et simple.
De préférence, un filtre esclave est constitué à partir de plusieurs cellules alors que un filtre maître en comporte une seule.
Ainsi le filtre maître est plus économique, sans dégrader aucune performance.
Avantageusement, les cellules sont du type à résistance-capacité, dont les résistances d'accord sont constituées par des transistors à effet de champ.

Ainsi, la commande de la fréquence centrale d'un filtre peut être obtenue facilement par une tension.
Chaque filtre étant réglable en gain au moyen d'une tension appliquée à une entrée de réglage de gain, le dispositif comporte avantageusement une connexion de prélèvement de signal à l'entrée du dispositif de filtrage, connexion équipée d'un filtre esclave spécifique, associé à un filtre maître spécifique, respectivement semblables aux autres filtres esclaves et maîtres, le dispositif étant muni de moyens pour caler la fréquence du filtre spécifique tour à tour sur la fréquence centrale de chacun des filtres du dispositif, lequel comporte en outre un circuit de comparaison du niveau du signal en sortie du filtre spécifique, par rapport à une valeur de consigne, des moyens de servo-régulation du niveau de signal de sortie du filtre spécifique, pour amener ce niveau à la dite valeur de consigne, des moyens de commutation pour fournir tour à tour à chacun des filtres esclaves la tension de réglage de gain du filtre spécifique, lorsque la fréquence du filtre spécifique correspond à celle désirée pour le filtre esclave, et des moyens de mémorisation provisoire pour chaque filtre esclave, de façon à y conserver la valeur de la tension de réglage de gain, pendant les périodes où le filtre esclave ne reçoit pas la tension de réglage de gain du filtre spécifique.
Ainsi le gain de toutes les voies peut être réglé de façon automatique et rester stable dans le temps.
Un système de distribution collective de télévision comprend avantageusement un dispositif de filtrage selon l'invention.
Ces aspects de l'invention tels que définis dans les revendications ainsi que d'autres aspects plus détaillés apparaîtront plus clairement grâce à la description suivante d'un mode de réalisation constituant un exemple non limitatif.
La figure 1 est un schéma d'une cellule de filtrage d'un filtre passe-bande.
La figure 2 représente schématiquement un filtre maître.
La figure 3 représente schématiquement un filtre passe-bande.
La figure 4 est un schéma d'un oscillateur.
La figure 5 représente schématiquement un circuit PLL.
La figure 6 est un schéma d'ensemble d'un dispositif de filtrage.
La figure 7 est un schéma d'ensemble d'une variante d'un dispositif de filtrage.

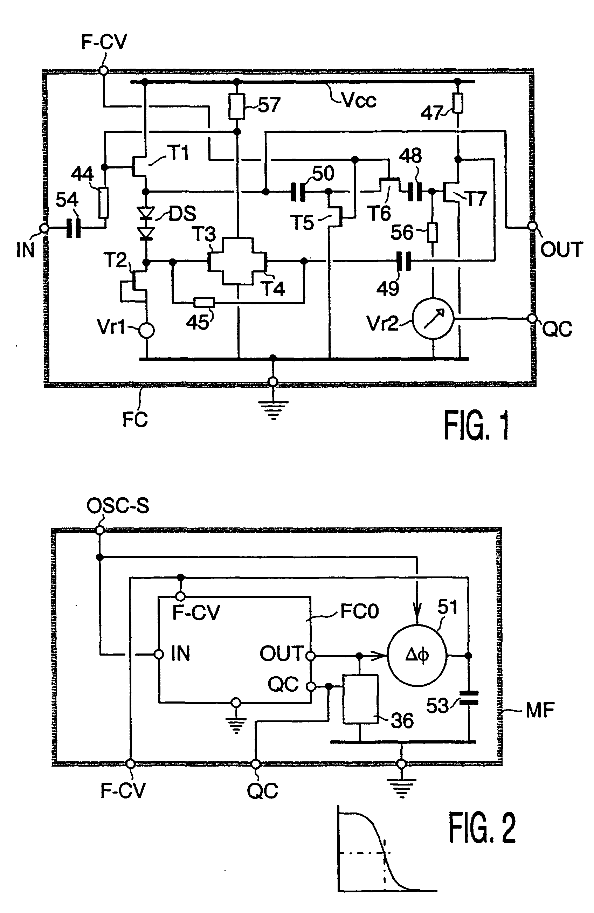

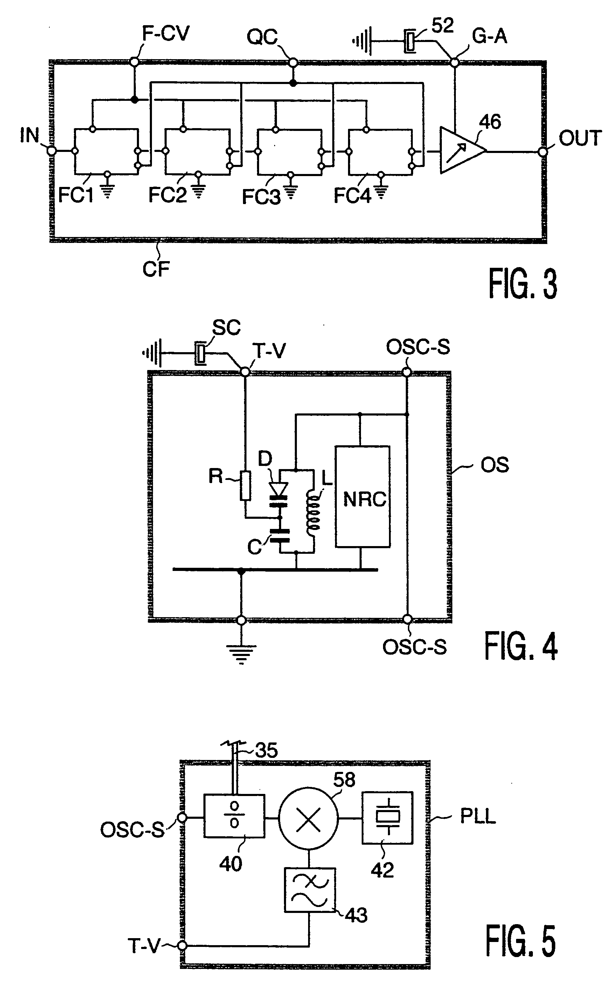

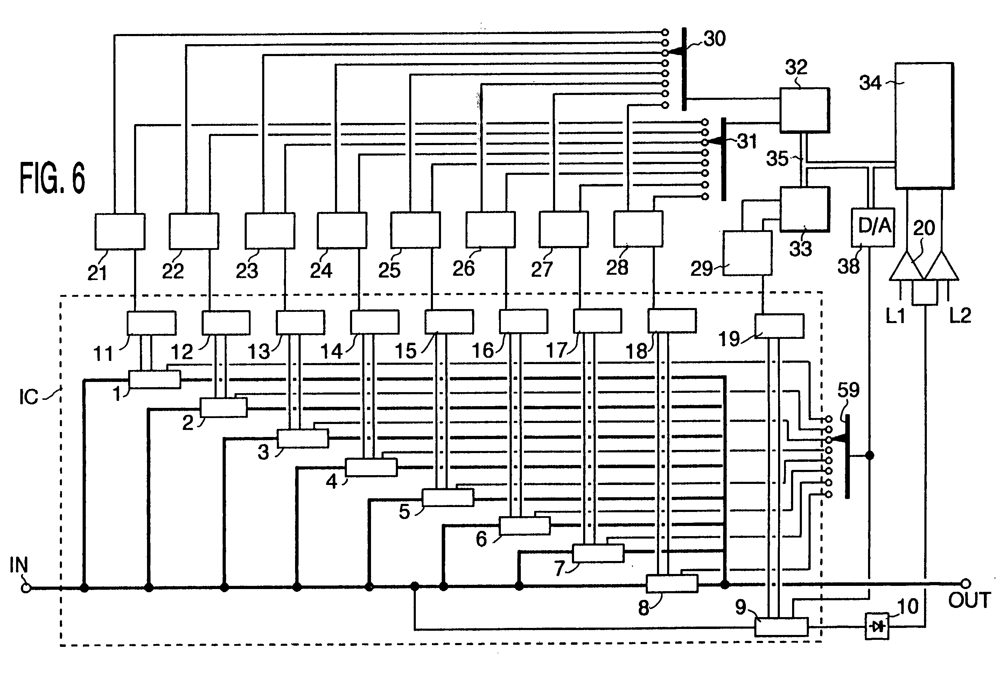

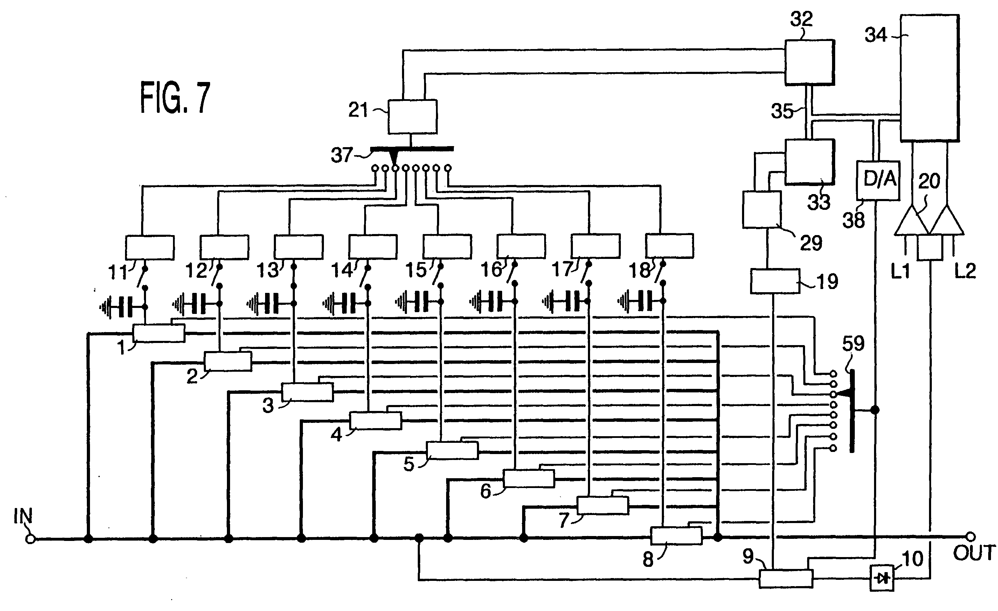

Le dispositif de filtrage qui va être décrit maintenant, destiné à traiter individuellement une pluralité de canaux (par exemple des canaux UHF) dans un système de distribution de télévision par câble, comporte entre autres des oscillateurs, des filtres passe-bande et des filtres maîtres, un ou plusieurs circuits PLL. Un signal de télévision dans un filtre sera appelé signal UHF. Un exemple de cellule de filtrage dont la fréquence centrale est commandée au moyen d'une tension de commande de fréquence, portant la référence FC sur la figure 1, comporte, dans le chemin du signal entrant par l'entrée IN, une capacité de liaison 54 en série avec une résistance 44, dans laquelle passe le courant de signal UHF. En aval de la résistance 44, le signal est amené à la grille d'un transistor à effet de champ T1, qui est monté en "source suiveuse" (son drain est relié à une source d'alimentation Vcc). La source de T1 est reliée à une tension de référence Vr1, via une ou plusieurs diodes en série DS et un transistor à effet de champ T2, dont la grille est reliée à la source. Le signal sur la source de T1 est amené à la source d'un transistor à effet de champ T7, via un réseau filtrant constitué par un ensemble capacité-résistance et un ensemble résistance-capacité en cascade. L'ensemble capacité-résistance est constitué par une capacité 50 et un transistor à effet de champ T5 faisant office de résistance variable. L'ensemble résistance-capacité est constitué un transistor à effet de champ T6 faisant office de résistance variable et par la capacité d'entrée du transistor à effet de champ T7. La capacité 48 est une capacité de liaison.
La grille du transistor à effet de champ T7 est polarisée au moyen d'une résistance 56 reliée à une tension de référence Vr2. La tension de cette source Vr2 peut être ajustée, au moyen d'une tension appliquée à une entrée d'ajustage de surtension QC. En faisant varier Vr2, on peut ajuster le gain du transistor T7, et en conséquence la surtension c'est-à-dire la largeur de bande de la cellule de filtrage. Le transistor à effet de champ T7 est chargé par une résistance 47 et délivre un signal de sortie sur son drain. Ce signal est amené via une capacité de liaison 49 à la grille d'un transistor à effet de champ T4, constituant une des deux entrées d'un montage à deux entrées constitué par les deux transistors à effet de champ T4 et T3. La seconde entrée du montage à deux entrées, constituée par la grille du transistor à effet de champ T3, est connectée au drain de T2, sur lequel est présent le même signal que sur la source du transistor à effet de champ T1, simplement décalé par les diodes DS. La grille de T4 est reliée à celle de T3 par une résistance 45, pour polariser T4. Le courant moyen du montage à deux entrées T3-T4 est absorbé par une charge 57 reliée à la source d'alimentation Vcc. L'extrémité de la charge 57, qui est reliée aux drains de T3 et T4, est en outre reliée à la grille de T1 et à la résistance 44. La fréquence caractéristique du réseau filtrant peut être commandée, du fait que les transistors à effet de champ T6 et T5 font office de résistances variables dans le réseau filtrant, et la commande de la fréquence centrale du filtre est donc obtenue en appliquant une tension de commande de fréquence à une entrée de tension de commande F-CV, reliée aux grilles des transistors à effet de champ T5 et T6. Le signal de sortie de la cellule de filtrage est prélevé sur la source de T1, qui est reliée à la sortie OUT. Le filtre décrit ci-dessus est un modèle de filtre possible parmi d'autres ; il va de soi que tout filtre connu, dont la fréquence peut être commandée par une tension, peut convenir également.
Un filtre maître, muni de moyens de servo-régulation pour aligner sa fréquence centrale avec la fréquence d'un signal fourni par un synthétiseur de fréquences, et générant la dite tension de commande de fréquence, est indiqué par MF sur la figure 2. Il comprend une cellule FC0, exactement conforme à la cellule FC de la figure 1. Pour faciliter l'identification des diverses entrées ou sorties dont la cellule FC0 de la figure 2 est munie, ces entrées ou sorties sont placées dans la même position, sur le cadre extérieur de la cellule, que dans la cellule FC de la figure 1. Un signal en provenance d'un oscillateur est amené à une entrée OSC-S du filtre maître MF, qui est reliée à l'entrée IN de la cellule FC0, et également à une entrée du comparateur de phase 51 à deux entrées. La sortie OUT de la cellule FC0 est reliée à la seconde entrée du comparateur de phase 51, pour comparer son signal au signal OSC-S. Le signal de comparaison, filtré par une capacité 53, est amené sur l'entrée de tension de commande F-CV de la cellule FC0 afin d'aligner sa fréquence centrale avec la fréquence OSC-S, et aussi sur une sortie F-CV du filtre maître MF lui même, pour être disponible afin de commander la fréquence de cellules de filtrage extérieures. En bas de la figure 2, une courbe représente l'allure de la variation de phase du signal entre l'entrée et la sortie de la cellule FC0, en fonction de la fréquence : le point indiqué par le croisement de deux lignes en trait mixte correspond à la fréquence centrale de la cellule FC0. En ce point, la phase varie très rapidement, ce qui a pour conséquence que la définition d'une phase donnée assure une commande de fréquence précise. Bien entendu, le comparateur 51 est conçu de façon à fournir un signal de comparaison nul pour le point en question.
Du fait que la surtension d'un filtre varie avec la fréquence, il est utile de prévoir un ajustage de la surtension. Un dispositif 36 est prévu à cet effet, il est connecté à la sortie OUT de la cellule FC0 afin de mesurer le niveau de sortie de la cellule FC0 et de réaliser une servo-régulation de ce niveau de sortie, par des moyens connus, en appliquant une tension adéquate sur l'entrée QC de la cellule FC0. Cette entrée QC est reliée à une sortie QC du filtre maître MF, pour ajuster la surtension d'un filtre passe-bande esclave.
Un filtre passe-bande, ou filtre esclave, référencé CF sur la figure 3, comprend, en cascade, plusieurs cellules du type représenté à la figure 1. Plusieurs cellules sont nécessaires pour obtenir la sélectivité recherchée, alors qu'une seule cellule suffit dans le filtre maître de la figure 2, où la sélectivité importe peu, puisque la fonction de la cellule maître est seulement de fournir le signal de commande de fréquence F-CV. Ici quatre cellules FC1, FC2, FC3, FC4 sont prévues. Pour faciliter l'identification des diverses entrées ou sorties des cellules FC1 à FC4 de la figure 3, leurs entrées ou sorties sont placées dans la même position, sur le cadre extérieur de la cellule, que dans la cellule FC de la figure 1. Les entrées de commande de fréquence de chaque cellule sont reliées, pour la commande de leur fréquence, à l'entrée de commande de fréquence F-CV du filtre complet. Pour simplifier, on a représenté une liaison commune entre l'entrée F-CV et les entrées de commande de chaque cellule de filtrage ; on pourrait aussi introduire un décalage approprié d'une cellule à l'autre, par exemple au moyen de diviseurs résistifs non représentés, pour que les fréquences soient légèrement décalées afin d'obtenir, par addition des filtrages des cellules, une plus grande largeur de bande. En cascade avec la cellule FC4 est placé un amplificateur 46 à gain réglable, dont une entrée de réglage de gain est reliée à une entrée de tension de réglage de gain G-A du filtre CF, dont la tension est mémorisée par une capacité réservoir 52. Cet amplificateur 46 pourrait également être placé à l'entrée IN, ou entre deux cellules, la meilleure position dépendant des performances désirées, en réalisant un compromis entre le rapport signal/bruit et la distorsion. Une entrée QC d'ajustage de surtension est connectée aux entrées d'ajustage de surtension de chacune des cellules FC1 à FC4.
Un oscillateur à fréquence variable, référencé OS sur la figure 4, comporte un circuit résonnant comprenant une inductance L et une capacité constituée d'un condensateur C en série avec une diode varicap D. Une tension de syntonisation est appliquée à une entrée T-V, qui est reliée à la cathode de la diode D par une résistance R. Cette tension de syntonisation est mémorisée dans une capacité réservoir SC, de façon à conserver sa valeur pendant les périodes où l'oscillateur n'est pas sélectionné, c'est-à-dire pendant que son entrée T-V n'est pas connectée à une tension de syntonisation.
Une oscillation est entretenue dans le circuit résonnant au moyen d'un circuit actif NRC, assimilable à une résistance négative, qui n'est pas représenté en détail, l'homme du métier n'ayant que l'embarras du choix parmi bien des types connus (par exemple : Hartley, Colpitts, Clapp, etc). Le signal UHF de l'oscillateur est amené sur des sorties OSC-S.
Un circuit PLL (figure 5), dans lequel une fréquence est définie par un diviseur de fréquence, comprend une entrée OSC-S pour un signal en provenance d'un oscillateur, par exemple un oscillateur du type représenté figure 4. Le signal de cette entrée OSC-S est appliqué à l'entrée d'un diviseur de fréquence 40, dont le rapport de division est programmé par un processeur, avec lequel le diviseur de fréquence 40 est relié par un bus 35. Le signal à fréquence divisée est amené à une entrée d'un comparateur de phase 58 à deux entrées. Le signal d'un oscillateur à quartz 42 connu est amené à la seconde entrée du comparateur 58. Le signal d'erreur en sortie du comparateur est filtré dans un filtre passe-bas 43 connu, et amené sur une borne de sortie de tension de syntonisation T-V, pour syntoniser l'oscillateur dont le signal UHF est amené sur l'entrée OSC-S du circuit PLL.
Un exemple de dispositif de filtrage complet (figure 6) comprend différentes entités qui ont pour la plupart été décrites ci-dessus, en regard des figures 1 à 5. Pour faciliter l'identification des diverses entrées ou sorties dont chacune de ces entités est munie, ces entrées ou sorties sont placées, dans la figure 6, à la même position sur leur cadre extérieur, que dans les figures 1 à 5. Pour simplifier la figure, les liaisons de masse ne sont pas représentées. Le signal est filtré entre une entrée IN et une sortie OUT. Entre l'entrée IN et la sortie OUT, le dispositif comporte huit voies en parallèle munies chacune d'un filtre passe-bande esclave, conforme à celui de la figure 3, référencé de 1 à 8, dont la fréquence centrale est commandée au moyen d'une tension de commande de fréquence, appliquée sur une entrée située sur la figure en haut à gauche de chaque filtre. A chaque filtre esclave 1-8 correspond un filtre maître référencé respectivement de 11 à 18. Chaque filtre maître est conforme à celui de la figure 2, et il est relié à un oscillateur, respectivement 21 à 28, conforme à celui de la figure 4. Ainsi la fréquence centrale de chaque filtre maître 11 à 18 est alignée avec la fréquence du signal fourni par l'oscillateur respectivement 21 à 28. Un synthétiseur de fréquences multiple est constitué par chacun des oscillateurs en liaison avec un circuit PLL unique 32. Un commutateur 30, actionné par un processeur 34, connecte tour à tour, au rythme d'une horloge connue non représentée, le signal de sortie (sortie OSC-S de la figure 4) de chacun des oscillateurs 21-28 à l'entrée de signal (entrée OSC-S de la figure 5) du circuit PLL 32. Un commutateur 31, actionné par le processeur 34, connecte tour à tour, en correspondance, la borne de sortie de tension de syntonisation (T-V sur la figure 5) du circuit PLL 32 aux entrées de syntonisation (T-V sur la figure 4) de chacun des oscillateurs. Le processeur 34 est programmé pour introduire des données sur un bus 35 de façon à programmer le rapport de division voulu du diviseur dans le circuit PLL 32, de façon a obtenir la fréquence désirée pour l'oscillateur qui est sélectionné par les commutateurs 30 et 31. Bien entendu, un bus d'adresses, non représenté pour simplifier la figure, permet de désigner l'élément qui est intéressé, à chaque instant, par les données. Pour commander la fréquence d'un filtre esclave 1-8 en même temps que celle du filtre maître correspondant 11-18, une entrée de tension de commande de fréquence d'un filtre esclave (entrée F-CV de la figure 3) est reliée à chaque fois à une sortie de tension de commande de fréquence du filtre maître correspondant (sortie F-CV de la figure 2) et, pour ajuster la surtension d'un filtre esclave 1-8 en même temps que celle du filtre maître correspondant 11-18, une entrée de tension d'ajustage de la surtension d'un filtre esclave (entrée QC de la figure 3) est reliée à chaque fois à la sortie de tension de tension d'ajustage de la surtension du filtre maître correspondant (sortie QC de la figure 2). Tous les couples faits d'un filtre esclave et d'un filtre maître correspondant sont réalisés, par intégration, sur un même substrat semi-conducteur, ce substrat étant indiqué par un cadre en trait mixte référencé IC. En variante, chaque couple pourrait aussi bien être réalisé sur un substrat séparé. Il y a donc un commutateur 30 par lequel transitent des tensions quasi-continues, et un commutateur 31 par lequel transitent des signaux haute-fréquence.
Le dispositif comporte en outre une connexion de prélèvement de signal, équipée d'un filtre spécifique 9, reliée à l'entrée IN du dispositif de filtrage. Le filtre spécifique 9 est associé à un filtre maître spécifique 19. Les filtres 9 et 19 sont respectivement semblables à un filtre esclave et à un filtre maître. Le filtre maître spécifique 19 est muni de moyens pour servo-réguler la fréquence centrale de sa cellule de filtrage en l'alignant avec la fréquence d'un signal fourni par un deuxième synthétiseur de fréquences constitué par un oscillateur 29 et un circuit PLL 33. Le processeur 34 fournit sur le bus 35 des données pour caler, tour à tour sur chacune des fréquences centrales désirées pour les filtres passe-bande, la fréquence définie par le circuit PLL 33. Un circuit de comparaison du niveau du signal en sortie du filtre spécifique 9 est constitué par un élément détecteur 10, qui fournit une tension proportionnelle au niveau du signal en sortie du filtre 9, et par des moyens pour comparer cette tension à une valeur de consigne, moyens constitués par deux comparateurs, à deux entrées, référencés 20, qui comparent le signal en sortie du filtre spécifique 9 avec respectivement deux niveaux de référence L1 et L2, et communiquent le résultat de la comparaison au processeur 34, lequel calcule une valeur de tension de réglage du gain du filtre spécifique, et la fournit à un convertisseur numérique-analogique 38, lequel l'applique à l'entrée de réglage du gain du filtre spécifique. Un commutateur 59, actionné par le processeur 34, fournit tour à tour, à chacun des filtres passe-bande 1 à 18, la tension de réglage du gain du filtre spécifique 9, lorsque la fréquence de l'oscillateur 29 correspond à celle désirée pour le filtre passe-bande. Comme on l'a expliqué plus haut, cette tension de réglage est mémorisée pour chaque filtre passe-bande.
En variante, le comparateur 20 pourrait agir directement sur le filtre spécifique 9 par des moyens analogiques connus, sans passer par le microprocesseur (34) et par une conversion numérique-analogique (38). L'élément détecteur 10 pourrait être intégré dans le substrat IC. On pourrait aussi supprimer les éléments 29 et 33. Alors le filtre maître spécifique 19 serait relié tour à tour à chacun des oscillateurs 21 à 28, par un commutateur supplémentaire, au même rythme que celui des commutateurs 30 et 31. Toutefois il n'est pas sûr qu'un commutateur supplémentaire ne coûterait pas plus cher que les éléments 29 et 33 ainsi économisés.
Un autre exemple de dispositif de filtrage complet, représenté à la figure 7, comprend les mêmes éléments que l'exemple de la figure 6, sauf les oscillateurs 22 à 28. A la place, il comprend un seul oscillateur 21, dont la sortie de signal UHF (OSC-S, figure 4) est reliée, au moyen d'un commutateur 37, tour à tour aux différentes entrées de signal UHF (OSC-S, figure 2) des différents filtres maîtres 11 à 18. La tension de commande de fréquence de chacun de ces filtres maîtres est amenée au filtre esclave correspondant, au moyen de huit interrupteurs insérés à chaque fois dans la connexion reliant un filtre esclave à un filtre maître, seulement pendant les périodes où la sortie de signal UHF de l'oscillateur 21 est reliée au filtre maître correspondant. Pour mémoriser la tension de commande de fréquence de chaque filtre esclave, une capacité, représentée à chaque fois au dessous de la référence 11 à 18 du filtre maître correspondant, est connectée à l'entrée de commande de fréquence de chaque filtre esclave. Si cette capacité devait être importante, elle ne pourrait pas être intégrée sur le même substrat que les filtres, ce qui obligerait à prévoir huit bornes de sorties supplémentaires pour les connecter à l'extérieur. Néanmoins, comme la tension F-CV est appliquée (cf figure 1) à des grilles de transistors à effet de champ dont la consommation de courant est à peu près nulle, les capacités en question peuvent avoir une faible valeur, et éventuellement être intégrées.

## Revendications

1. Dispositif de filtrage dans lequel, à un filtre dit esclave comportant au moins une cellule dont la fréquence centrale est commandée par une tension appliquée à une entrée de commande de fréquence, correspond un filtre maître muni d'une cellule d'un type identique à celui employé dans le filtre esclave et de moyens de servo-régulation pour aligner, au moyen d'une tension de commande de fréquence, la fréquence centrale de cette cellule avec la fréquence d'un signal fourni par un synthétiseur de fréquences composé d'un oscillateur à fréquence variable et d'un circuit de rétro-action dit PLL qui génère une tension de syntonisation de l'oscillateur, dispositif dans lequel, pour aligner la fréquence du filtre esclave, la dite tension de commande est appliquée en même temps à l'entrée de commande de fréquence du filtre maître et à celle du filtre esclave, **caractérisé en ce que,** le dispositif de filtrage étant adapté pour traiter individuellement une pluralité de canaux dans un système de distribution de télévision par câble comportant une pluralité de voies en parallèle munies chacune d'un filtre esclave de type passe-bande, le dispositif comporte autant de filtres maîtres et d'oscillateurs que de filtres esclaves, tous étant réalisés par intégration sur un même substrat semi-conducteur, et un seul circuit PLL, des moyens de commutation étant prévus pour sélectionner tour à tour les différents oscillateurs, en amenant le signal de l'oscillateur sélectionné au circuit PLL et en ramenant à cet oscillateur la tension de syntonisation issue du circuit PLL, ainsi que des moyens pour caler la fréquence définie par le circuit PLL sur la fréquence désirée pour l'oscillateur qui est sélectionné, et un moyen de mémorisation provisoire pour chaque oscillateur, de façon à conserver la valeur de la tension de syntonisation, pendant des périodes où il n'est pas sélectionné.

2. Dispositif de filtrage selon la revendication 1, **caractérisé en ce que** le dit moyen de mémorisation provisoire pour chaque oscillateur est constitué essentiellement par un condensateur réservoir.

3. Dispositif de filtrage dans lequel, à un filtre dit esclave comportant au moins une cellule dont la fréquence centrale est commandée par une tension appliquée à une entrée de commande de fréquence, correspond un filtre maître muni d'une cellule d'un type identique à celui employé dans le filtre esclave et de moyens de servo-régulation pour aligner, au moyen d'une tension de commande de fréquence, la fréquence centrale de cette cellule avec la fréquence d'un signal fourni par un synthétiseur de fréquences composé d'un oscillateur à fréquence variable et d'un circuit de rétro-action dit PLL qui génère une tension de syntonisation de l'oscillateur, dispositif dans lequel, pour aligner la fréquence du filtre esclave, la dite tension de commande est appliquée en même temps à l'entrée de commande de fréquence du filtre maître et à celle du filtre esclave, **caractérisé en ce que**, le dispositif de filtrage étant adapté pour traiter individuellement une pluralité de canaux dans un système de distribution de télévision par câble comportant une pluralité de voies en parallèle munies chacune d'un filtre esclave de type passe-bande, le dispositif comporte autant de filtres maîtres que de filtres esclaves, tous étant réalisés par intégration sur un même substrat semi-conducteur, et un seul oscillateur, dont la sortie de signal est reliée, au moyen d'un commutateur, tour à tour aux différentes entrées de signal des différents filtres maîtres, et la tension de commande de fréquence de chacun de ces filtres maîtres est amenée au filtre esclave correspondant, au moyen d'une pluralité d'interrupteurs insérés à chaque fois dans la connexion reliant un filtre esclave à un filtre maître et qui sont fermés seulement pendant les périodes où la sortie de signal de l'oscillateur est reliée au filtre maître correspondant.

4. Dispositif de filtrage selon la revendication 3, **caractérisé en ce que**, pour mémoriser la tension de commande de fréquence de chaque filtre esclave, une capacité est connectée à l'entrée de commande de fréquence de chaque filtre esclave.

5. Dispositif de filtrage selon l'une quelconque des revendications 1 à 4, **caractérisé en ce qu'**un filtre esclave est constitué à partir de plusieurs cellules alors que un filtre maître en comporte une seule.

6. Dispositif de filtrage selon l'une quelconque des revendications 1 à 5, **caractérisé en ce que** les cellules sont du type à résistance-capacité, dont les résistances d'accord sont constituées par des transistors à effet de champ.

7. Dispositif de filtrage selon l'une quelconque des revendications 1 à 6, dont chaque filtre esclave est réglable en gain au moyen d'une tension appliquée à une entrée de réglage de gain, **caractérisé en ce qu'**il comporte une connexion de prélèvement de signal à l'entrée du dispositif de filtrage, connexion équipée d'un filtre esclave spécifique, associé à un filtre maître spécifique, respectivement semblables aux autres filtres esclaves et maîtres, le dispositif étant muni de moyens pour caler la fréquence du filtre spécifique tour à tour sur la fréquence centrale de chacun des filtres du dispositif, lequel comporte en outre un circuit de comparaison du niveau du signal en sortie du filtre spécifique, par rapport à une valeur de consigne, des moyens de servo-régulation du niveau de signal de sortie du filtre spécifique, pour amener ce niveau à la dite valeur de consigne, des moyens de commutation pour fournir tour à tour à chacun des filtres esclaves la tension de réglage de gain du filtre spécifique, lorsque la fréquence du filtre spécifique correspond à celle désirée pour le filtre esclave, et des moyens de mémorisation provisoire pour chaque filtre esclave, de façon à y conserver la valeur de la tension de réglage de gain, pendant les périodes où le filtre esclave ne reçoit pas la tension de réglage de gain du filtre spécifique.

8. Système de distribution collective de télévision, **caractérisé en ce que** il comprend un dispositif de filtrage selon l'une quelconque des revendications précédentes.

## Claims

1. A filtering device in which a master filter corresponds to a slave filter
comprising at least a cell whose central frequency is controlled by a voltage applied to a frequency control input, which master filter is provided with a cell of a type identical to that used in the slave filter and with servocontrol means for aligning, by means of a frequency control voltage, the central frequency of this cell with the frequency of a signal supplied by a frequency synthesizer which is composed of a variable frequency oscillator and a feedback circuit referred to as PLL which generates a voltage for tuning the oscillator, in which device said control voltage is simultaneously applied to the frequency control input of the master filter and to that of the slave filter so as to align the frequency of the slave filter, **characterized in that** the filtering device, being adapted to individually treat a plurality of channels in a cable television distribution system comprising a plurality of parallel paths each provided with a slave filter of the bandpass type, comprises as many master filters and oscillators as slave filters, all being realized by means of integration on the same semiconductor substrate, and a single PLL circuit, while switching means are provided for selecting the different oscillators in turns by applying the signal from the selected oscillator to the PLL circuit and applying to this oscillator the tuning voltage from the PLL circuit, as well as means for adjusting the frequency defined by the PLL circuit at the frequency desired for the selected oscillator, and a provisional storage means for each oscillator for storing the value of the tuning voltage during periods when said oscillator is not selected.

2. A filtering device as claimed in claim 1, **characterized in that** said provisional storage means for each oscillator is constituted essentially by a storage capacitor.

3. A filtering device in which a master filter corresponds to a slave filter comprising at least a cell whose central frequency is controlled by a voltage applied to a frequency control input, which master filter is provided with a cell of a type identical to that used in the slave filter and with servocontrol means for aligning, by means of a frequency control voltage, the central frequency of this cell with the frequency of a signal supplied by a frequency synthesizer which is composed of a variable frequency oscillator and a feedback circuit referred to as PLL which generates a voltage for tuning the oscillator, in which device said control voltage is simultaneously applied to the frequency control input of the master filter and to that of the slave filter so as to align the frequency of the slave filter, **characterized in that** the filtering device, being adapted to individually treat a plurality of channels in a cable television distribution system comprising a plurality of parallel paths each provided with a slave filter of the bandpass type, comprises as many master filters as slave filters, all being realized by means of integration on the same semiconductor substrate, and a single oscillator whose signal output is connected in turns to the different signal inputs of the different master filters by means of a switch, and the frequency control voltage of each master filter is supplied to the corresponding slave filter by means of a plurality of switches inserted each time in the connection connecting a slave filter to a master filter and closed only during the periods when the signal output of the oscillator is connected to the corresponding master filter.

4. A filtering device as claimed in claim 3, **characterized in that** a capacitance is connected to the frequency control input of each slave filter so as to store the frequency control voltage of each slave filter.

5. A filtering device as claimed in any one of claims 1 to 4, **characterized in that** a slave filter is constituted by a plurality of cells, whereas a master filter comprises a single cell.

6. A filtering device as claimed in any one of claims 1 to 5, **characterized in that** the cells are of the resistance-capacitance type, in which the tuning resistances are constituted by field effect transistors.

7. A filtering device as claimed in any one of claims 1 to 6, in which each filter is gain-controllable by means of a voltage applied to a gain control input, **characterized in that** the device comprises a connection for taking a signal from the input of the filtering with a specific master filter which are similar to other slave filters and master filters, respectively, and is provided with means for adjusting the frequency of the specific filter in turns at the central frequency of each filter of the device, the device also comprising a circuit for comparing the level of the signal at the output of the specific filter with a nominal value, means for servocontrol of the level of the output signal of the specific filter for bringing this level to said nominal value, switching means for supplying, in turns, the gain control voltage of the specific filter to each slave filter, while the frequency of the specific filter corresponds to that desired for the slave filter, and provisional storage means for each slave filter for storing the value of the gain control voltage during the periods when the slave filter does not receive the gain control voltage of the specific filter.

8. A collective television distribution system, **characterized in that** the system comprises a filtering device as claimed in any one of the preceding claims.

## Patentansprüche

1. Filtervorrichtung, in der ein sogenannter Nebenfilter mindestens eine Zelle aufweist, deren Mittelfrequenz von einer einem Frequenzsteuereingang zugeführten Spannung gesteuert wird, entsprechend einem Hauptfilter, mit einer identischen Zelle wie der im Nebenfilter verwendeten versehen, und Servoregulierungsverfahren zur Ausrichtung, mittels einer Frequenzsteuerspannung, der Mittelfrequenz dieser Zelle auf die Frequenz eines von einem Frequenzaufbereiter gelieferten Signals, bestehend aus einem Oszillator variabler Frequenz und einer Rückkopplungsschaltung mit der Bezeichnung PLL, die eine Abstimmspannung des Oszillators erzeugt, eine Vorrichtung, in der zur Ausrichtung der Nebenfilterfrequenz die besagte Spannung zugleich dem Frequenzsteuereingang des Hauptfilters und dem des Nebenfilters zugeführt wird, **dadurch gekennzeichnet, daß** die Filtervorrichtung angepaßt ist zur einzelnen Verarbeitung einer Vielzahl von Kanälen in einem Kabelfernsehverteilungssystem mit einer Vielzahl paralleler Wege, jeweils mit einem Bandbreitennebenfilter versehen, wobei die Vorrichtung ebenso viele Hauptfilter und Oszillatoren wie Nebenfilter aufweist, alle integriert auf einem selben Halbleitersubstrat gefertigt, und eine einzige PLL-Schaltung, und Schaltverfahren vorgesehen sind, um der Reihe nach die verschiedenen Oszillatoren auszuwählen, indem das ausgewählte Oszillatorsignal der PLL-Schaltung zugerührt wird und indem in diesen Oszillator die Abstimmspannung aus der PLL-Schaltung zurückgeführt wird, sowie Verfahren zum Feststellen der von der PLL-Schaltung definierten Frequenz auf die für den Oszillator gewünschten Frequenz, der ausgewählt ist, und ein provisorisches Speicherverfahren für jeden Oszillator, um den Wert der Abstimmspannung über die Zeiträume beizubehalten, in denen er nicht ausgewählt ist.

2. Filtervorrichtung nach Anspruch 1, **dadurch gekennzeichnet, daß** die besagten provisorischen Speicherverfahren für jeden Oszillator hauptsächlich aus einem Speicherkondensator besteht.

3. Filtervorrichtung, in der ein sogenannter Nebenfilter mindestens eine Zelle aufweist, deren Mittelfrequenz von einer einem Frequenzsteuereingang zugeführten Spannung gesteuert wird, entsprechend einem Hauptfilter, mit einer identischen Zelle wie der im Nebenfilter verwendeten versehen, und Servoregulierungsverfahren zur Ausrichtung, mittels einer Frequenzsteuerspannung, der Mittelfrequenz dieser Zelle auf die Frequenz eines von einem Frequenzaufbereiter gelieferten Signals, bestehend aus einem Oszillator variabler Frequenz und einer Rückkopplungsschaltung mit der Bezeichnung PLL, die eine Abstimmspannung des Oszillators erzeugt, eine Vorrichtung, in der zur Ausrichtung der Nebenfilterfrequenz die besagte Spannung zugleich dem Frequenzsteuereingang des Hauptfilters und dem des Nebenfilters zugeführt wird, **dadurch gekennzeichnet, daß** die Filtervorrichtung angepaßt ist zur einzelnen Verarbeitung einer Vielzahl von Kanälen in einem Kabelfernsehverteilungssystem mit einer Vielzahl paralleler Wege verwendet, jeweils mit einem Bandbreitennebenfilter versehen, wobei die Vorrichtung ebenso viele Hauptfilter wie Nebenfilter aufweist, alle integriert auf einem selben Halbleitersubstrat gefertigt, und einem einzigen Oszillator, dessen Signalausgang über einen Schalter der Reihe nach mit den verschiedenen Signaleingängen der verschiedenen Hauptfilter verbunden wird, und die Frequenzsteuerspannung jedes dieser Hauptfilter wird dem dementsprechenden Nebenfilter zugeführt, mittels einer Vielzahl von Schaltern, jedesmal in die Verbindung zwischen einem Nebenfilter und einem Hauptfilter eingebracht, und die nur über die Zeiträume gesperrt sind, in denen das Ausgangssignal eines Oszillators mit dem dementsprechenden Hauptfilter verbunden ist.

4. Filtervorrichtung nach Anspruch 3, **dadurch gekennzeichnet, daß** zum Speichern der Frequenzsteuerspannung jedes Nebenfilters eine Kapazität an den Frequenzsteuereingang jedes Nebenfilters angeschlossen wird.

5. Filtervorrichtung nach einem beliebigen der Ansprüche 1 bis 4, **dadurch gekennzeichnet, daß** ein Nebenfilter aus einer Vielzahl Zellen gebildet wird, während ein Hauptfilter eine einzige aufweist.

6. Filtervorrichtung nach einem beliebigen der Ansprüche 1 bis 5, **dadurch gekennzeichnet, daß** die Zellen vom Typ Widerstand-Kapazität sind, wobei die Abstimmwiderstände aus Feldeffekttransistoren gebildet werden.

7. Filtervorrichtung nach einem beliebigen der Ansprüche 1 bis 6, wobei die Leistung jedes Nebenfilters steuerbar ist, mittels einer einem Leistungssteuereingang zugeführten Spannung, **dadurch gekennzeichnet, daß** sie eine Verbindung zur Signalentnahme am Eingang der Filtervorrichtung enthält, wobei die Verbindung mit einem spezifischen Nebenfilter versehen ist, in Verbindung mit einem spezifischen Hauptfilter, respektive den anderen Neben- und Hauptfiltern ähnlich, die Vorrichtung mit Verfahren versehen ist, um die spezifische Filterfrequenz der Reihe nach auf die Mittelfrequenz jedes Filters der Vorrichtung festzustellen, sie zudem eine Schaltung zum Vergleich des Signalniveaus am Ausgang des spezifischen Filters in bezug auf einen Vorgabewert aufweist, Servoregulierungsverfahren des Signalniveaus am Ausgang des spezifischen Filters, um dieses Niveau auf den besagten Vorgabewert zu bringen, Schaltverfahren, um der Reihe nach jedem der Nebenfilter die Leistungssteuerspannung des spezifischen Filters zuzuführen, wenn die Frequenz des spezifischen Filters der für den Nebenfilter gewünschten entspricht, und provisorische Speicherverfahren für jeden Nebenfilter, um den Wert der Leistungssteuerspannung über die Zeiträume beizubehalten, in denen er die Leistungssteuerspannung des spezifischen Filters nicht erhält.

8. Gemeinschaftsfernsehverteilungssystem, **dadurch gekennzeichnet, daß** es eine Filtervorrichtung nach einem beliebigen der vorangehenden Ansprüche enthält.
